Europäisches Patentamt

European Patent Office

Office européen des brevets

(19)

(11) Veröffentlichungsnummer : **0 129 251**
**B1**

(12) **EUROPÄISCHE PATENTSCHRIFT**

(45) Veröffentlichungstag der Patentschrift :
07.09.88

(51) Int. Cl.⁴ : **G 01 S 7/02, H 03 B 5/18**

(21) Anmeldenummer : 84107056.8

(22) Anmeldetag : 19.06.84

(54) Streifenleitungsdopplerradar.

(30) Priorität : 21.06.83 DE 3322304

(43) Veröffentlichungstag der Anmeldung :
27.12.84 Patentblatt 84/52

(45) Bekanntmachung des Hinweises auf die Patenterteilung : 07.09.88 Patentblatt 88/36

(84) Benannte Vertragsstaaten :
AT CH DE FR GB IT LI SE

(56) Entgegenhaltungen :
EP-A- 0 048 189
EP-A- 0 061 952
EP-A- 0 064 000
WO-A-83 /033 09
FR-A- 2 438 937
ELECTRONIC COMPONENTS AND APPLICATIONS, Band 4, Nr. 4, August 1982, Seiten 227-232, Eindhoven, NL; B.J. VAN DER HEIJDEN: "Dielectric-resonator-oscillators- a new microwave signal source"
ELEKTRONIK, Heft 31, Nr. 18, 10. September 1982, Seiten 57-60, München, DE; DR. G. WOLFRAM: "Dielektrische Resonatoren"
MATERIALS RESEARCH BULLETIN, Band 16, 1981, Seiten 1455-1463, Oxford, GB; G. WOLFRAM et al.: "Existence range, structural and dielectric properties of ZrxTiySnzO4 ceramics (X+Y+Z=2)"
IEEE TRANSACTIONS ON MICROWAVE THEORY AND TECHNIQUES, Band MTT-28, Nr. 8, August 1980, Seiten 817-824, New York, US; O. ISHIHARA et al.: "A highly stabilized GaAs FET oscillator using a dielectric resonator feedback circuit in 9-14 GHz"

(73) Patentinhaber : Siemens Aktiengesellschaft Berlin und München
Wittelsbacherplatz 2
D-8000 München 2 (DE)

(72) Erfinder : Müller, Jörg, Dr.-Ing.
Meilsener Heide 9
D-2110 Buchholz (DE)
Erfinder : Reppekus, Andreas, Dipl.-Ing.
Balanstrasse 69
D-8000 München 90 (DE)

**Beschreibung**

Die Erfindung betrifft ein Streifenleitungsdopplerradar.

Aus der DE-OS 3 019 887 ist ein Dopplerradar für den Frequenzbereich von 9,3 GHz bis 10,7 GHz bekannt, das eine relativ große Geometrie aufweist. Wegen der für die Hohlleiterabmessungen geltenden Wellenlängenbeziehung läßt sich die Geometrie eines solchen Dopplerradars nicht ohne weiteres reduzieren. Ein Ausweichen zu höheren Frequenzen hin, z. B. zu 24 GHz statt 10 GHz, verringert zwar einerseits die dazu erforderliche Geometrie, erhöht aber andererseits die Anforderung an die Fertigungstoleranzen. Gleichzeitig erhöhen sich bei kleineren Geometrien die Leistungsverluste beim Abstimmen an hierzu vorgesehenen Abstimmschrauben. Außerdem ist die Frequenzvariation bei Dopplerradars mit Hohlleiteraufbau nur in relativ engen Grenzen möglich, die die Anwendung derartiger Geräte in unterschiedlichen Ländern mit unterschiedlichen zugelassenen Frequenzen stark einengt.

Aus der Druckschrift WO-A-8 303 309 ist ein Dopplerradar in Streifenleitungstechnik bekannt. Dadurch ergibt sich eine flache, raumsparende Bauweise, eine einfache Herstellung und eine hohe betriebliche Zuverlässigkeit der Vorrichtung. Diese Druckschrift WO-A-8 303 309 ist nicht vorveröffentlicht.

Aufgabe der vorliegenden Erfindung ist es, ein Dopplerradar mit geringen geometrischen Abmessungen, mit hoher Zuverlässigkeit, leichter Variationsmöglichkeit der erzeugten Frequenz und einfach einstellbarer Empfindlichkeit anzugeben, bei dem eine gegenseitige Anpassung von Sende-Bauelementen und Empfangsbauelementen innerhalb einer gewissen Bandbreite leicht erreicht wird.

Diese Aufgabe wird durch ein Streifenleitungs-Dopplerradar nach dem Anspruch 1 gelöst.

Das erfindungsgemäße Streifenleitungsdopplerradar 1 enthält also einen Hochfrequenzoszillator 3, einen ersten Streifenleiter 5 einen zweiten Streifenleiter 6, einen dielektrischen Resonator 2, eine Empfangsdiode 7, eine Antenne 4 und Bandsperren oder Tiefpaßfilter 9, 10. Die Bandsperren bzw. Tiefpaßfilter 9, 10 sind so angebracht, daß ein Abfluß von hochfrequenter Leistung über Niederfrequenz führende äußere elektrische Anschlüsse 13, 14 verhindert wird und die Bestandteile sind so zusammengeschaltet, daß von dem Hochfrequenzoszillator 3 abgegebene Leistung über die Streifenleiter 5, 6 und den dielektrischen Resonator 2 sowohl zu der oder den Empfangsdioden 7 als auch zu der Antenne 4 gelangt. Weiterhin ist der erste Streifenleiter 5 in einem solchen Abstand vom zweiten Streifenleiter 6 angebracht, daß eine Anbringung und Lagejustierung des dielektrischen Resonators 2 zum Teil auf und/oder zwischen den Streifenleitern 5, 6 erfolgen kann.

Durch die Lagejustierung des dielektrischen Resonators 2 kann gleichzeitig sowohl die über die Antenne 4 abgestrahlte Leistung, die über die Antenne 4 empfangene Leistung und die vom Hochfrequenzoszillator 3 über den dielektrischen resonator 2 direkt auf die Empfangsdiode bzw. die Empfangsdioden 7 übertragene Leistung, die sogenannte Pumpleistung, eingestellt werden.

Durch die Verwendung eines dielektrischen Resonators anstelle von Hohlraumresonatoren lassen sich geringe geometrische Abmessungen und eine hohe Zuverlässigkeit erreichen, da mit den Hohlraumresonatoren auch die dafür typischen Fehlerquellen wie Wackelkontakte an Abstimmschrauben und ähnliches entfallen. Eine Variation der verwendeten Frequenz läßt sich durch eine Variation der Abmessungen des dielektrischen Resonators erreichen. Die Einstellbarkeit der Empfindlichkeit ist mit der Lagejustierung des dielektrischen Resonators relativ zu dem senderseitigen Streifenleiterzweig bzw. zu dem empfängerseitigen Streifenleiterzweig möglich. Damit wird auch gleichzeitig eine Anpassung von Sendebauelementen und Empfangsbauelementen innerhalb einer gewissen Bandbreite erreicht.

Durch die Anordnung des erfindungsgemäßen Streifenleitungsdopplerradars erübrigt sich die Verwendung von Koppelkondensatoren, die im allgemeinen zur Trennung der Gleichspannung des Oszillatorelements und der Empfängerdioden angebracht werden. Dadurch ergeben sich geringere Hochfrequenzverluste, weniger reflektierende Stoßstellen im Verlauf der Streifenleiter und weniger Kontaktstellen. Ein solches Dopplerradar ist somit zuverlässiger und billiger.

Es ist vorteilhaft, daß die Streifenleiter 5, 6, der dielektrische Resonator 2, der Hochfrequenzoszillator 3, die Empfangsdiode bzw. Dioden 7 und die Bandsperren bzw. Tiefpaßfilter 9, 10 auf einem isolierenden, gemeinsamen Substrat 11 aufgebracht sind. Durch diese Maßnahme wird die Fertigung wesentlich vereinfacht. Eine derartige Fertigung läßt sich auch automatisierbar gestalten.

Es ist auch vorteilhaft, daß der erste Streifenleiter 5, an einem Ende an den Hochfrequenzausgang des Hochfrequenzoszillators 3 angeschlossen ist, und am anderen Ende einen Abschlußwiderstand 8 aufweist, und daß der Abschlußwiderstand 8 als Widerstandsschicht auf dem Substrat 11 ausgebildet ist.

Der Abschlußwiderstand vermeidet, daß ein erheblicher Teil der vom Hochfrequenzoszillator erzeugten Leistung am Ende des Streifenleiters 5 reflektiert wird. Dadurch erhält der senderseitige Streifenleiterresonator eine so geringe Güte, daß die Schwingfrequenz nur vom dielektrischen Resonator bestimmt wird. Das erfindungsgemäße Dopplerradar weist außerdem eine schwache Überkopplung der Oszillatorleistung aus dem Oszillatorzweig in den Empfangszweig von ca. 10 dB auf, weshalb die Dämpfung des Empfangssignals entsprechend gering ist. Durch eine Anbringung des Abschlußwiderstandes auf dem Substrat als Widerstandsschicht ist die Herstellung des Abschlußwiderstandes technisch einfach.

Weiterhin ist es vorteilhaft, daß als Hochfrequenzoszillator 3 eine Impattdiode oder eine Barittdiode oder ein Feldeffekttransistor verwendet wird.

Es ist auch vorteilhaft, daß als Hochfrequenzoszillator 3 ein Gunnelement verwendet wird und daß als Empfangsdiode bzw.-Dioden 7 Schottkydioden verwendet werden und

daß die optimalen Leitungslängen zwischen den Koppelstellen des dielektrischen Resonators 2 einerseit und dem Gunnelement bzw. der oder den Schottkydioden andererseits ca. λ/4 bis λ/2 betragen, wobei λ die leitungswellenlänge der im Dopplerradar erzeugten Schwerpunktfrequenz des zugehörigen Frequenzbandes bedeutet.

Es ist vorteilhaft, daß das Streifenleitungsdopplerradar ein Gehäuse 20 aus elektrisch leitfähigem Material aufweist, bei dem die elektrischen Anschlüsse 13, 14, 15 als elektrisch isolierte Durchführungen ausgebildet sind und bei dem oberhalb des dielektrischen Resonators 2 eine ins Gehäuseinnere eingeführte Abstimmschraube ragt, die zur Abstimmung des Resonators 2 dient. Das elektrisch leitende Gehäuse schirmt das Gehäuseinnere elektrisch und mechanisch ab. Mit der Abstimmschraube läßt sich die durch die Geometrie vorgegebene Frequenz des dielektrischen Resonators innerhalb einer gewissen Bandbreite variieren, was bei der verwendung derartiger Apparate in verschiedenen Ländern mit verschiedenen zugelassenen Frequenzbereichen von großer Wichtigkeit ist.

Es ist vorteilhaft, daß zur Frequenzabstimmung des dielektrischen Resonators 2 dessen geometrische Abmessungen durch Materialabtragung verringert werden, was z. B. durch mechanisches Abschleifen, Abtragen mittels eines Laserstrahls oder ähnlichen Methoden erfolgen kann.

Es ist vorteilhaft, daß zur Frequenzabstimmung des dielektrischen Resonators 2 Schichten unterschiedlicher Dielektrizitätskonstante und/oder unterschiedlicher Schichtdicke auf den Resonator 2 aufgebracht werden und

daß die Schichten aus Harzen oder Lacken bestehen, die wahlweise mit dielektrischen Füllstoffen angereichert sind. Als Harze oder Lacke kommen hierfür insbesondere Epoxid-Harze, Polyester und Acryl-Harze in Frage, deren relativ Dielektrizitätskonstante möglichst hoch ist, ca. 40 beträgt.

Als Füllstoff kann z. B. Titandioxid verwendet werden.

Es ist auch vorteilhaft, daß der dielektrische Resonator 2 zylinderförmig ist und

daß der dielektrische Resonator 2 aus Al$_2$O$_3$-Keramik, Bariumtetratitanat oder aus einem Zirkontitanzinnoxid der Formel (Zr$_x$Ti$_y$Sn$_z$)O$_4$ besteht, wobei x + y + z = 2 ist.

Dabei haben sich verschiedene Zirkontitanzinnoxide, insbesondere (Zr$_{0,5}$TiSn$_{0,5}$)O$_4$, als besonders geeignet erwiesen, da sich im Bereich der Anwendungstemperatur keine starken Frequenzänderungen eines solchen Resonators in Abhängigkeit von der Temperatur ergeben oder da die temperaturbedingten Frequenzänderungen den Temperaturgang des Hochfrequenzoszillators kompensieren.

Nachfolgend wird die Erfindung anhand der Zeichnung und an Ausführungsbeispielen näher erläutert.

Es zeigen :

Fig. 1 einen Schnitt durch das erfindungsgemäß Streifenleitungsdopplerradar parallel zu den Symmetrieachsen der äußeren elektrischen Anschlüsse.

Fig. 2 einen Schnitt des erfindungsgemäßen Streifenleitungsdopplerradars längs der strichpunktierten Linie II-II aus Fig. 1 senkrecht zur Zeichenebene der Fig. 1.

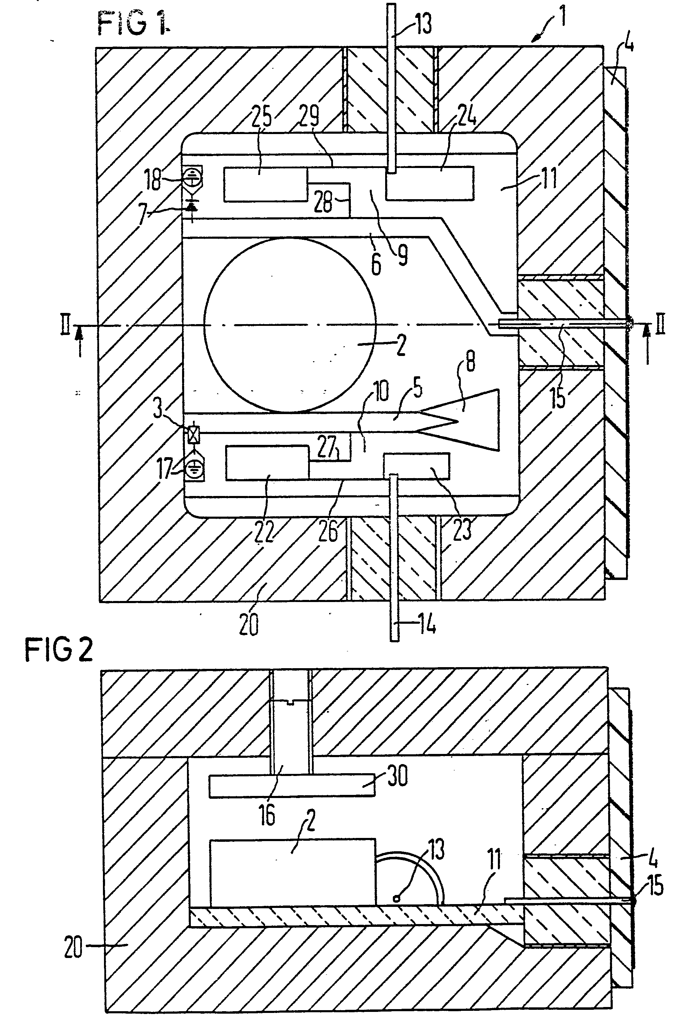

Fig. 1 zeigt den wesentlichen Aufbau eines erfindungsgemäßen Streifenleitungsdopplerradars 1. Auf einem isolierenden Substrat 11, das z. B. aus Al$_2$O$_3$-Keramik, Quarz, Teflon oder glasfaserverstärktem Teflon besteht, ist eine Streifenschaltung bestehend aus dem Streifenleiter 5 und dem Streifenleiter 6 angebracht, zwischen denen ein dielektrischer z. B. zylinderförmiger Resonator 2 angebracht ist, der beispielsweise aus Bariumtetratitanat, Al$_2$O$_3$-Keramik oder aus einem Zirkontitanzinnoxid der Formel :

(Zr$_x$Ti$_y$Sn$_z$)O$_4$   mit   x + y + z = 2   bestehen kann. Der Resonator 2 kann so angebracht sein, daß ein Teil der Resonatorfläche einen Teil der Fläche des Streifenleiters 5 und/oder einen Teil der Fläche des Streifenleiters 6 überdeckt, oder daß der Resonator 2 die Streifenleiter 5 und 6 tangiert, oder daß der Resonator 2 keine der Flächen der Streifenleiter 5 und 6 überdeckt, oder tangiert.

An dem einen Ende des Streifenleiters 5 ist ein Hochfrequenzoszillator 3 angebracht, der z. B. aus einem Gunnelement, einer Impattdiode, einer Barittdiode oder einem Feldeffekttransistor besteht. Das andere Ende des Streifenleiters 5 ist mit einem Abschlußwiderstand 8 versehen, der z. B. als Widerstandsschicht auf dem Substrat 11 aufgebracht sein kann und aus Titan, oder Graphit oder Palladium bestehen kann. An einem Ende des Streifenleiters 6 ist mindestens eine Empfangsdiode 7 z. B. bestehend aus einer Schottky-Diode angebracht, am anderen Ende ist der Streifenleiter 6 über einen elektrischen Anschluß 15 mit der Antenne 4 verbunden. Bei der Verwendung einer Schottky-Diode als Empfangsdiode 7 und eines Gunnelementes als Hochfrequenzoszillator 3 wird der dielektrische Resonator 2 so justiert, daß die optimalen Leitungslängen zwischen den Koppelstellen des dielektrischen Resonators 2 einerseits und dem Gunnelement bzw. der Schottky-Diode andererseits ca. λ/4 bis λ/2 betragen, wobei λ die Leitungswellenlänge der Schwerpunktfrequenz des im Dopplerradar erzeugten zugehörigen Frequenzbandes ist.

Der andere Anschluß des Hochfrequenzoszillators der nicht mit dem Streifenleiter 5 verbunden ist, wird über die Durchkontaktierung 17 mit dem Gehäuse 20 verbunden und somit geerdet, was in der Zeichnung durch das entsprechende Symbol dargestellt ist. Entsprechend wird der zweite nicht mit dem Streifenleiter 6 verbundene Anschluß der Empfangsdiode 7 mittels der Durchkontaktierung 18 ebenfalls geerdet.

Anstelle der einen dargestellten Empfangsdiode 7 können auch mehrere Empfangsdioden verwendet werden.

Durch ein Verschieben des Resonators 2 relativ zu den Streifenleitern 5 und 6 wird gleichzeitig die abgestrahlte Frequenz, die abgestrahlte Leistung und die von dem Oszillator an die Empfangsdiode direkt abgegebene Leistung die sog. Pumpleistung, und somit auch die Empfindlichkeit der Empfangsdiode bezüglich der Empfangsleistung geregelt.

Die Leistungsübertragung vom oszillatorseitigen Streifenleiter 5 zum empfangsseitigen Streifenleiter 6 erfolgt mit einer Koppeldämpfung von ca. 10 dB. Dadurch ist die Schwächung von Dopplersignalen die sehr dicht an der Trägerfrequenz liegen, empfangsseitig entsprechend gering und die Schottky-Diode weist somit eine praktisch optimale Empfindlichkeit auf, zumal die Schottky-Diode an den Sendezweig für optimale Empfindlichkeit angekoppelt ist. Über die Bandpaßfilter bzw. Tiefpaßfilter 9, 10 werden dem Hochfrequenzoszillator 3 und der Empfangsdiode 6 Gleichspannungen bzw. Dopplerspannungen zu bzw. abgeführt. Durch die Verwendung des Resonators 2 als Koppler, des Schichtwiderstandes 8 und einer geeignet ausgeführten Antenne 4, die keine galvanische Verbindung zwischen Streifenleiter und Gehäuse erzeugt, erübrigen sich Koppelkondensatoren, da die Gleichspannung überall automatisch abgeblockt wird. Die Tiefpaßfilter bzw. Bandsperren 9 und 10 lassen sich z. B. durch Anbringung metallisierter Flächen 22, 23, 24, 25 auf dem Substrat 11, die Kapazitäten bzw. niederohmige $\lambda/4$-Leitungen sind, und dünne Streifenmetallisierungen 26, 27, 28 und 29 ebenfalls auf dem Substrat 11, die Induktivitäten bzw. hochohmige $\lambda/4$-Leitungen sind, realisieren. Die Metallisierungen für die Streifenleiter und die Tiefpaßfilter auf dem Substrat 11 können z. B. aus Titan, Platin, Gold oder Chrom, Kupfer, Gold bestehen. Vom Tiefpaßfilter 9 führt ein glasvergossener elektrischer Anschluß 13 in Form eines Koaxial-Teiles durch das umgebende Gehäuse 20 nach außen ; entsprechend ist am Tiefpaßfilter 10 ein äußerer elektrischer Anschluß 14 angebracht. Ein weiterer entsprechend ausgeführter elektrischer Anschluß ist zwischen dem Streifenleiter 6 und der Antenne 4 angebracht. Das gesamte Streifenleiterdopplerradar ist von einem Gehäuse aus leitfähigem Material umgeben.

Das Substrat 11 ist so in das Gehäuse 20 eingefügt, daß es an diejenige Gehäusewand bündig anschließt an der der elektrische Anschluß 15 angebracht ist, der zur Antenne 4 führt. An den drei übrigen Kanten kann das Substrat 11 einen gewissen Abstand zum Gehäuse 20 aufweisen. Für eine Sendefrequenz von 9,35 GHz und ein $Al_2O_3$-Substrat läßt sich z. B. ein annähernd quadratisches Substrat mit der Kantenlänge von ca. 13 mm und eine Dicke von 0,6 mm verwenden. Das Gehäuse kann z. B. quaderförmig sein mit den Abmessungen Länge ca. 20 mm, Breite ca. 18 mm, Höhe ca. 14 mm. An derjenigen Gehäuseaußenfläche, an der der elektrische Anschluß 15 angebracht ist, ist großflächig die hochfrequenztaugliche Antenne 4 angebracht, die z. B. als Streifenleiterantenne ausgebildet sein kann und aus glasfaserverstärktem und beidseitig metallisiertem Teflon bestehen kann oder auch als ein in einen Hohlleiter hineinragender Stift ausgeführt sein kann.

Fig. 2 zeigt einen Querschnitt durch das erfindungsgemäße Streifenleitungsdopplerradar längs der strichpunktierten Linie II-II aus Fig. 1 und senkrecht zur Zeichenebene. Gleiche Gegenstände von Fig. 1 sind mit gleichen Bezugszeichen versehen und werden nicht nochmals beschrieben. Oberhalb des dielektrischen Resonators 2 ist eine Abstimmschraube 16 angebracht mit deren Hilfe eine Abstimmschraube 16 angebracht mit deren Hilfe eine kreisförmige metallische Platte 30 in einem bestimmten Abstand zum dielektrischen Resonator 2 angebracht werden kann. Durch die Abstimmschraube 16 mit der Platte 30 läßt sich die Frequenz des dielektrischen Resonators zwischen ca. 9,2 GHz und 10,2 GHz variieren. Alternativ dazu kann die Frequenz auch durch geometrische Veränderungen der Abmessungen oder durch dielektrische Beschichtung des Resonators 2 abgestimmt werden.

Das am elektrischen Anschluß 13 abgenommene Dopplersignal wird mittels eines rauscharmen Verstärkers verstärkt und anschließend ausgewertet.

Das erfindungsgemäße Streifenleitungsdopplerradar läßt sich z. B. als Bewegungsmelder, Geschwindigkeitsmesser, Türöffner oder zur Ampelsteuerung verwenden.

**Patentansprüche**

1. Streifenleitungsdopplerradar, gekennzeichnet durch folgende Bestandteile :
   (i) einen Hochfrequenzoszillator (3),
   (ii) einen ersten Streifenleiter (5),
   (iii) einen zweiten Streifenleiter (6),
   (iv) einen dielektrischen Resonator (2),
   (v) mindestens eine Empfangsdiode (7),
   (vi) Filtereinrichtungen (9, 10) mit Tief- und Bandpaßcharakteristik zur Isolierung der die Versorgungsspannung sowie das Dopplersignal führenden Anschlüsse (13, 14) von der Hochfrequenz, mit folgenden Merkmalen :
   — der Hochfrequenzoszillator (3) ist mit dem ersten Streifenleiter (5) und dieser über den dielektrischen Resonator (2) mit dem zweiten Streifenleiter (6) hochfrequenzmäßig gekoppelt,
   — der zweite Streifenleiter (6) ist außerdem mit der oder den Empfangsdiode(n) (7) sowie mit einer Antenne (4) gekoppelt,
   — der dielektrische Resonator (2) ist zur Einstellung der Kopplung der beiden Streifenleiter (5, 6) zwischen den beiden Streifenleitern entweder unter Wahrung jeweils eines vorgegebenen Abstands zu diesen Leitern oder unter Überlappung eines oder beider Streifenleiter derart angeordnet, daß der Antenne (4) sowie der oder den Empfangsdiode(n) jeweils eine vorgegebene Leistung zugeführt wird.

2. Streifenleitungsdopplerradar nach Anspruch 1, dadurch gekennzeichnet, daß die Streifenleiter (5, 6), der dielektrische Resonator (2), der Hochfrequenzoszillator (3), die Empfangsdiode bzw. -dioden (7) und die Bandsperren bzw. Tiefpaßfilter (9, 10) auf einem isolierenden, gemeinsamen Substrat (11) aufgebracht sind.

3. Streifenleitungsdopplerradar nach einem der Ansprüche 1 oder 2, dadurch gekennzeichnet, daß der erste Streifenleiter (5), an einem Ende an den Hochfrequenzausgang des Hochfrequenzoszillators (3) angeschlossen ist, und am anderen Ende einen Abschlußwiderstand (8) aufweist.

4. Streifenleitungsdopplerradar nach Anspruch 3, dadurch gekennzeichnet, daß der Abschlußwiderstand (8) als Widerstandsschicht auf dem Substrat (11) ausgebildet ist. .

5. Streifenleitungsdopplerradar nach einem der Ansprüche 1 bis 4, dadurch gekennzeichnet, daß der zweite Streifenleiter (6) einerseits leitend mit der Antenne (4) und andererseits leitend mit der bzw. den Empfangsdioden (7) verbunden ist.

6. Streifenleitungsdopplerradar nach einem der Ansprüche 1 bis 5, dadurch gekennzeichnet, daß als Hochfrequenzoszillator (3) eine Impattdiode oder eine Barittdiode oder ein Feldeffekttransistor verwendet wird.

7. Streifenleitungsdopplerradar nach einem der Ansprüche 1 bis 5, dadurch gekennzeichnet, daß als Hochfrequenzoszillator (3) ein Gunnelement verwendet wird.

8. Streifenleitungsdopplerradar nach einem der Ansprüche 1 bis 7, dadurch gekennzeichnet, daß als Empfangsdiode bzw. -dioden (7) Schottky-Dioden verwendet werden.

9. Streifenleitungsdopplerradar nach Anspruch 7 und 8, dadurch gekennzeichnet, daß die Leitungslängen zwischen den Koppelstellen des dielektrischen Resonators (2) einerseits und dem Gunnelement bzw. der oder den Schottkydioden andererseits. $\lambda/4$ bis $\lambda/2$ betragen, wobei $\lambda$ die Leitungswellenlänge der Schwerpunktsfrequenz des zugehörigen im Dopplerradar erzeugten Frequenzbandes bedeutet.

10. Streifenleitungsdopplerradar nach einem der Ansprüche 1 bis 9, dadurch gekennzeichnet, daß ein Gehäuse (20) aus elektrisch leitfähigem Material vorgesehen ist, bei dem die elektrischen Anschlüsse (13, 14, 15) als elektrisch isolierte Durchführungen ausgebildet sind.

11. Streifenleitungsdopplerradar nach einem der Ansprüche 1 bis 10, dadurch gekennzeichnet, daß zur Frequenzabstimmung des dielektrischen Resonators (2) oberhalb des dielektrischen Resonators (2) eine Abstimmschraube (16) angebracht ist.

12. Streifenleitungsdopplerradar nach einem der Ansprüche 1 bis 11, dadurch gekennzeichnet, daß zur Frequenzabstimmung des dielektrischen Resonators (2) dessen geometrische Abmessungen durch Materialabtragung geeignet gewählt sind.

13. Streifenleitungsdopplerradar nach einem der Ansprüche 1 bis 11, dadurch gekennzeichnet, daß zur Frequenzabstimmung des dielektrischen Resonators (2) dieser mit Schichten unterschiedlicher Dielektrizitätskonstante und/oder unterschiedlicher Schichtdicke versehen ist.

14. Streifenleitungsdopplerradar nach Anspruch 13, dadurch gekennzeichnet, daß die Schichten aus Harzen oder Lacken bestehen, die wahlweise mit dielektrischen Füllstoffen angereichert sind.

15. Streifenleitungsdopplerradar nach einem der Ansprüche 1 bis 14, dadurch gekennzeichnet, daß der dielektrische Resonator (2) zylinderförmig ist.

16. Streifenleitungsdopplerradar nach Anspruch 14, dadurch gekennzeichnet, daß die Füllstoffe und/oder der dielektrische Resonator (2) aus $Al_2O_3$-Keramik, Bariumtetratitanat oder aus einem Zirkontitanzinnoxid der Formel: $(Zr_xTi_ySn_z)O_4$ bestehen, wobei $x + y + z = 2$ ist.

**Claims**

1. A strip line Doppler radar, characterised by the following components :
    (i) a high-frequency oscillator (3) ;
    (ii) a first strip conductor (5) ;
    (iii) a second strip conductor (6) ;
    (iv) a dielectric resonator (2) ;
    (v) at least one receiving diode (7) ; and
    (iv) filter devices (9, 10) with low-pass and band-pass characteristics for isolating the terminals (13, 14) which conduct the supply voltage and the Doppler signal from the high frequency, comprising the following features :
    — the high-frequency oscillator (3) is high-frequency coupled to the first strip conductor (5) and the latter via the dielectric resonator (2) to the second strip conductor (6),
    — the second strip conductor (6) is also coupled to the receiving diode(s) (7) and to an antenna (4),
    — for setting the coupling of the two strip conductors (5, 6), the dielectric resonator (2) is arranged between the two strip conductors either maintaining a predetermined distance from these conductors, or overlapping one or both strip conductors in such manner that the antenna (4) and the receiving diode(s) are each supplied with a predetermined power.

2. A strip line Doppler radar device as claimed in Claim 1, characterised in that the strip conductors (5, 6), the dielectric resonator (2), the high-frequency oscillator (3), the receiving diode or diodes (7), and the band-stop or low-pass filters (9, 10) are arranged on an insulating, common substrate (11).

3. A strip line Doppler radar device as claimed in one of Claims 1 or 2, characterised in that the first strip conductor (5) is connected at one end to the high-frequency output of the high-frequency oscillator (3), and, at its other end, is provided with a terminal resistor (8).

4. A strip line Doppler radar device as claimed in Claim 3, characterised in. that the terminal resistor (8) consists of a resistive coating on the substrate (11).

5. A strip line Doppler radar device as claimed in one of Claims 1 to 4, characterised in that the second strip conductor (6) is, on the one hand, conductively-connected to the antenna (4) and, on the other hand, conductively-connected to the receiving diode(s) (7).

6. A strip line Doppler radar device as claimed in one of Claims 1 to 5, characterised in that the high-frequency oscillator (3) consists of an Impatt diode, a Baritt diode, or a field-effect transistor.

7. A strip line Doppler radar device as claimed in one of Claims 1 to 5, characterised in that a Gunn element is used as a high-frequency oscillator (3).

8. A strip line Doppler radar device as claimed in one of Claims 1 to 7, characterised in that Schottky diodes are used as receiving diode(s) (7).

9. A strip line Doppler radar device as claimed in Claim 7 and 8, characterised in that the line lengths between the coupling points of the dielectric resonator (2) on the one hand, and the Gunn element or Schottky diode(s) on the other hand amount to $\lambda/4$ to $\lambda/2$, where $\lambda$ is the line wavelength of the weighted centre frequency of the associated frequency band produced in the Doppler radar device.

10. A strip line Doppler radar device as claimed in one of Claims 1 to 9, characterised in that a housing (20) is provided which consists of electrically-conductive material in which electrically-insulated lead-through terminals (13, 14, 15) are provided.

11. A strip line Doppler radar device as claimed in one of Claims 1 to 10, characterised in that, for the frequency tuning of the dielectric resonator (2), a tuning screw (16) is arranged above the dielectric resonator (2).

12. A strip line Doppler radar device as claimed in one of Claims 1 to 11, characterised in that, for the frequency tuning of the dielectric resonator (2), the geometric dimensions thereof are suitably selected by the removal of material.

13. A strip line Doppler radar device as claimed in one of Claims 1 to 11, characterised in that, for the frequency tuning of the dielectric resonator (2), the latter is provided with layers having a different dielectric constant and/or a different layer thickness.

14. A strip line Doppler radar device as claimed in Claim 13, characterised in that the layers consist of resins or lacquers which are optionally enriched with dielectric fillers.

15. A strip line Doppler radar device as claimed in one of Claims 1 to 14, characterised in that the dielectric resonator (2) is cylindrical.

16. A strip line Doppler radar device as claimed in Claim 14, characterised in that the fillers and/or the dielectric resonator (2) consist of $Al_2O_3$-ceramic, barium-tetratitanate, or a zirconium-titanium-tin oxide of the formula :

$(Zr_xTi_ySn_z)O_4$, where $x + y + z = 2$.

**Revendications**

1. Radar Doppler à conducteurs en forme de bandes, caractérisé par les composants suivants :

(i) un oscillateur haute fréquence (3),

(ii) un premier conducteur en forme de bande (5),

(iii) un second conducteur en forme de bande (6),

(iv) un résonateur diélectrique (2),

(v) au moins une diode réceptrice (7),

(vi) des dispositifs de filtrage (9, 10) possédant une caractéristique de filtre passe-bas et de filtre passe-bande, servant à isoler les bornes (13, 14), appliquant la tension d'alimentation ainsi que le signal Doppler, vis-à-vis de la haute fréquence, comportant les caractéristiques suivantes :

— l'oscillateur haute fréquence (3) est accouplé, du point de vue de la haute fréquence, au premier conducteur en forme de bande (5) et ce dernier est accouplé, du point de vue de la haute fréquence, au second conducteur en forme de bande (6) par l'intermédiaire du résonateur diélectrique (2),

— le second conducteur en forme de bande (6) est accouplé en outre à la ou aux diodes réceptrices (7) ainsi qu'à une antenne (4),

— le résonateur diélectrique (2) est disposé, pour réaliser le réglage de l'accouplement des deux conducteurs en forme de bandes (5, 6), entre ces deux conducteurs en forme de bandes soit de manière à conserver des distances respectives prédéterminées par rapport à ces conducteurs, soit de manière à chevaucher l'un des deux ou les deux conducteurs en forme de bandes, de telle sorte que des puissances respectives prédéterminées sont envoyées à l'antenne (4) ainsi qu'à la ou aux diodes réceptrices.

2. Radar Doppler à conducteurs en forme de bandes selon la revendication 1, caractérisé en ce que les conducteurs en forme de bandes (5, 6), le résonateur diélectrique (2), l'oscillateur à haute fréquence (3), la ou les diodes réceptrices (7) et les filtres coupe-bande ou les filtres passe-bas (9, 10) sont disposés sur un substrat isolant commun (11).

3. Radar Doppler à conducteurs en forme de bandes suivant l'une des revendications 1 ou 2, caractérisé par le fait qu'une extrémité du premier conducteur en forme de bande (5) est raccordée à la sortie haute fréquence de l'oscillateur haute fréquence (3) et que son autre extrémité possède une résistance de terminaison (8).

4. Radar Doppler à conducteurs en forme de bandes suivant la revendication 3, caractérisé par le fait que la résistance de terminaison (8) est réalisée sous la forme d'une couche résistive sur le substrat (11).

5. Radar Doppler à conducteurs en forme de bandes suivant l'une des revendications 1 à 4, caractérisé par le fait que le second conducteur en forme de bande (6) est relié selon une liaison conductrice d'une part à l'antenne (4) et d'autre part à la ou aux diodes réceptrices (7).

6. Radar Doppler à conducteurs en forme de bandes suivant l'une des revendications 1 à 5, caractérisé par le fait qu'on utilise comme oscillateur haute fréquence (3) une diode à avalanche à temps de transit ou une diode Baritt ou un transistor à effet de champ.

7. Radar Doppler à conducteurs en forme de bandes suivant l'une des revendications 1 à 5, caractérisé par le fait qu'on utilise comme oscillateur haute fréquence un élément à effet Gunn.

8. Radar Doppler à conducteurs en forme de bandes suivant l'une des revendications 1 à 7, caractérisé par le fait qu'on utilise comme diode(s) réceptrice(s) (7), des diodes Schottky.

9. Radar Doppler à conducteurs en forme de bandes suivant les revendications 7 et 8, caractérisé par le fait les longueurs des conducteurs entre les points de couplage du résonateur diélectrique (2) d'une part et l'élément à effet Gunn ou la ou les diodes Schottky d'autre part sont comprises entre $\lambda/4$ et $\lambda/2$, $\lambda$ désignant la longueur d'onde dans les conducteurs, correspondant à la fréquence barycentrique de la bande associée de fréquences, produite dans le radar Doppler.

10. Radar Doppler à conducteurs en forme de bandes suivant l'une des revendications 1 à 9, caractérisé par le fait qu'il est prévu un boîtier (20) réalisé en un matériau électriquement conducteur et dans lequel les bandes électriques (13, 14, 15) sont réalisées sous la forme de traversées isolées du point de vue électrique.

11. Radar Doppler à conducteurs en forme de bandes suivant l'une des revendications 1 à 10, caractérisé par le fait que pour réaliser l'accord en fréquence du résonateur diélectrique (2), une vis de réglage d'accord (16) est disposée au-dessus du résonateur diélectrique (2).

12. Radar Doppler à conducteurs en forme de bandes suivant l'une des revendications 1 à 11, caractérisé par le fait que pour l'accord en fréquence du résonateur diélectrique (2), les dimensions géométriques de ce dernier sont choisies d'une manière appropriée au moyen d'un enlèvement de matière.

13. Radar Doppler à conducteurs en forme de bandes suivant l'une des revendications 1 à 11, caractérisé par le fait que pour l'accord en fréquence du résonateur diélectrique (2), ce dernier comporte des couches possédant des constantes diélectriques différentes et/ou des épaisseurs différentes.

14. Radar Doppler à conducteurs en forme de bandes suivant la revendication 13, caractérisé par le fait que les couches sont constituées par des résines ou des laques, qui sont enrichies, au choix, par des matières de charge diélectriques.

15. Radar Doppler à conducteurs en forme de bandes suivant l'une des revendications 1 à 4, caractérisé par le fait que le résonateur diélectrique (2) possède une forme cylindrique.

16. Radar Doppler à conducteurs en forme de bandes suivant la revendication 14, caractérisé par le fait que les matières de charge et/ou le résonateur diélectrique (2) sont constituées par de la céramique à base de $Al_2O_3$, par du tétratitanate de baryum ou par un oxyde de zirconium-titane-étain, répondant à la formule : $(Zr_xTi_ySn_z)O_4$, avec $x + y + z = 2$.

**FIG 1.**

**FIG 2**